# EUROPEAN PATENT SPECIFICATION

(11) **EP 2 822 033 B1**
(45) Date of publication and mention of the grant of the patent: **29.11.2017**
(21) Application number: 14172469.0
(22) Date of filing: 16.06.2014
(51) Int. Cl.: H01L 25/065, H05K 1/03, H05K 1/09, H05K 3/22, H05K 3/36, H01L 23/00, H01L 25/00

(54) **Formation of conductive circuit**
Herstellung einer leitenden Schaltung
Formation de circuit conducteur

(30) Priority: 19.06.2013 JP 2013128637
(43) Date of publication of application: 07.01.2015
(73) Proprietor: Shin-Etsu Chemical Co., Ltd., Tokyo (JP)
(72) Inventor: Hamada, Yoshitaka, Fukushima (JP)
(74) Representative: Ter Meer Steinmeister & Partner

(56) References cited:
- US-A1- 2006 014 309
- US-A1- 2006 276 584
- US-A1- 2010 244 251
- US-A1- 2012 207 917
- US-A1- 2013 092 423

## Description

### TECHNICAL FIELD

This invention relates to a method for forming a conductive circuit using a conductive ink composition, more particularly, to a method for forming a conductive circuit using a printing technique and a silicone rubber as the structural material of printed pattern, which is recovered for rewording.

### BACKGROUND ART

The technology of forming a conductive circuit by printing an ink composition containing conductive particles is already commercially implemented, for example, in the solar cell application wherein a conductive circuit is formed on a cell substrate by screen printing. A number of improvements in this technology have been proposed. For example, Patent Document 1 discloses that a conductive ink composition containing metal particles and glass frit, which is commonly used in the art, is printed by screen printing with the aid of ultrasonic oscillation. This method enables high speed formation of conductive circuits.

A problem arises when a circuit is formed on a semiconductor circuit board using a conductive ink composition based on glass. If the board is heated after circuit formation for substrate bonding or packaging purpose, the conductive ink composition may be cracked or otherwise stressed to cause a resistance change or breakage to the conductor. There is a need for a circuit-forming material having high stress resistance. Silicone material is characterized by heat resistance and stress relaxation. Patent Document 2 discloses that an ink composition comprising a thermoplastic resin, epoxy-modified silicone, metal powder, and silicone rubber elastomer is diluted with a solvent and used to form a conductive circuit which is not cracked or adversely affected on heat treatment. It is also known that conductive particles are dispersed in silicone rubber to form an ink composition.

The current trend is toward miniaturization of semiconductor circuits, and the size of concomitant conductive circuits also becomes finer. Also efforts are made on the so-called 3D semiconductor device, that is, a stacked semiconductor circuit structure obtained by forming a semiconductor circuit on a substrate, and stacking two or more such substrates. When such fine semiconductor circuits are provided with a plurality of contacts and packaged, or when interconnects are formed between semiconductor circuits on two or more silicon substrates, the conductive circuit to be connected is not only required to be resistant to thermal stress, but also needs to control its shape as fine structure.

For instance, if a conductive circuit including lines of different width is formed using a conductive ink composition containing a solvent, the flatness or shape of conductor lines may change in some areas before and after curing, or a height difference of the circuit may develop under the influence of certain factors such as the volatilization rate of the solvent. If connection is achieved while taking into account the influence, the margin for miniaturization may be lost. In attempts to achieve further miniaturization of semiconductor devices or to construct 3D stacking of semiconductor devices, it would be desirable to have a technology of forming a conductive circuit using a conductive ink composition that allows for stricter control of the circuit shape.

The above-mentioned ink composition having metal particles dispersed in silicone rubber becomes useful in forming a conductive circuit by printing when a thixotropic agent is added thereto. The printed circuit maintains its shape unchanged before and after curing. Further the circuit thus formed has a high stress relaxation ability to thermal stress or the like. However, when only conductive particles having a particle size of at least 5 µm contributing to least thixotropy are used, a problem arises with regard to conduction to electrodes. Although the resistivity of the bulk can be controlled in accordance with the amount of conductive particles added, there are available least conductive paths between conductive particles in the silicone rubber composition and electrodes, which may lead to a high contact resistance. An improvement in this respect is desired.

### Citation List

Patent Document 1: JP-A 2010-149301
Patent Document 2: JP-A H11-213756
Patent Document 3: JP-A 2007-053109
Patent Document 4: JP-A H07-109501

US 2006/0014309 A1 discloses a method for temporary chip attach comprising applying reworkable conductive adhesive bumps that are exposed to a rework solution.

US 2013/0092423 A1 discloses a method for forming a conductive circuit by printing an ink comprising an organopolysiloxane having at least two silicon-bonded alkenyl groups, an organohydrogenpolysiloxane, conductive particles, a thixotropic agent, and a hydrosilylation catalyst.

US 2010/0244251 A1 discloses a method for forming a conductive circuit comprising the steps of depositing a metal-containing film on a first substrate to form a circuit pattern, placing the circuit pattern in contact with a metal electrode on a second substrate and bonding the first and second substrates together.

### DISCLOSURE OF INVENTION

An object of the invention is to provide a method for forming a conductive circuit by printing and a recovering and a reworking step, ensuring that the conductive circuit is effectively printed, and the conductive circuit thus printed retains its shape before and after curing, has low contact resistance with electrodes, has a stress relaxation ability with respect to thermal stress or the like, and establishes a tight bond to the electrode.

The inventor sought for a material capable of meeting the above requirements. Since a silicone-forming material offers a fluidity necessary for an ink composition to be printed without a need for solvent, it is conceived that a silicone composition (to be defined below) may be printed to form a conductive circuit which undergoes no shape change before and after curing and has a stress relaxation ability.

Research is further made on a thixotropic agent for enhancing thixotropy such that the steric shape formed by printing may not deform until it is heat cured.

Since dry silica is most often used for the purpose of enhancing thixotropy, an experiment was first made to add dry silica to silicone rubber. As the amount of silica added increases, thixotropy increases, and electrical resistance also increases. It was thus difficult to obtain a composition which meets both thixotropy and electrical conduction. Then carbon black having a medium resistivity of the order of 1 Ω·cm or a similar thixotropic agent is added. Quite unexpectedly, it was found that as the amount of carbon black or similar thixotropic agent added increases, thixotropy increases and electrical resistance remains unchanged or rather decreases. This type of agent makes it possible to control thixotropy without taking into account conductivity. Thus, a satisfactory conductive circuit-imaging ink composition is obtainable by blending carbon black or similar thixotropic agent.

The inventor has reached an effective method for forming a conductive circuit using this conductive circuit-imaging ink composition, which method establishes formation of a conductive circuit and bonding between the conductive circuit and a metal electrode at the same time, and a recovering and a reworking step.

The invention provides a conductive circuit forming method comprising a recovering and a reworking step as defined in the claims.

### ADVANTAGEOUS EFFECTS OF INVENTION

The method for forming a conductive circuit according to the invention establishes formation of a conductive circuit and bonding between the conductive circuit (replacing solder bumps) and a metal electrode at the same time. As long as the distance to the electrode is controlled at the time of bonding, curing and bonding can be accomplished in one step of firing a circuit pattern after printing.

If it is difficult to control the distance to the metal electrode at the time of bonding, an electrode layer configured to have a predetermined height is previously formed on the metal electrode, and then curing and bonding can be accomplished in one step of firing a circuit pattern after printing. It is noted that the electrode layer may be formed by printing and curing a conductive ink composition, or by the well-known bump forming method using copper, gold, solder or the like. When the electrode layer is formed by the screen printing technique, the ink composition used in this screen printing technique and the conductive circuit-imaging ink composition need not necessarily be identical. However, it is advantageous for enhancing the bond strength at the interface that both the compositions are based on the same base resin. The amount of the conductive circuit-imaging ink composition used in this case may be a minimum sufficient for bonding and need not necessarily be equal to the amount used where no electrode layer is formed.

The conductive circuit-imaging ink composition is thixotropic and effectively printable. The method of the invention ensures that a conductive circuit is formed from the thixotropic ink composition by printing techniques, typically screen printing. There are many advantages including a low ohmic resistance, good shape reproduction of printed circuits, high-speed printing, high throughputs and yields of pattern formation. The circuit as printed retains its shape even during the cure step following printing, leading to high-level control of the circuit shape. Because of the silicone rubber-based structure, the printed circuit has a stress relaxation ability with respect to thermal stress or the like.

Where a solder electrode is used as the counter electrode, the solder bump rework technique may be used as such during the rework step of the process.

### BRIEF DESCRIPTION OF DRAWINGS

FIG. 1 illustrates, in cross section, a first embodiment not of the invention, (A) showing first and second substrates prior to their bonding, and (B) showing the substrates bonded together.
FIG. 2 illustrates, in cross section, a second embodiment not of the invention, (A) showing first and second substrates prior to their bonding, and (B) showing the substrates bonded together.
FIG. 3 illustrates, in cross section, a third embodiment not of the invention, (A) showing first and second substrates prior to their bonding, and (B) showing the substrates bonded together.
FIG. 4 illustrates, in cross section, a fourth embodiment not of the invention, (A) showing first and second substrates prior to their bonding, and (B) showing the substrates bonded together.
FIG. 5 illustrates, in cross section, a fifth embodiment not of the invention, (A) showing first and second substrates prior to their bonding, and (B) showing the substrates bonded together.
FIG. 6 illustrates, in cross section, a seventh embodiment of the invention, (A) showing first and second substrates prior to their bonding, and (B) showing the substrates bonded together.
FIG. 7 illustrates, in cross section, an eighth embodiment of the invention, (A) showing first and second substrates prior to their bonding, and (B) showing the substrates bonded together.

### DESCRIPTION OF PREFERRED EMBODIMENTS

As used herein, the term "conductive" refers to electrical conduction. The term "powder" is sometimes used as a collection of particles.

The conductive circuit-imaging ink composition used herein is a substantially solvent-free, liquid ink composition comprising a silicone rubber precursor (components A and B) in combination with a curing catalyst (component E), conductive particles (component C), and a thixotropic agent (component D).

For high-precision control of the shape of a conductive circuit pattern during printing and subsequent curing, it is desirable to cure the pattern formed in the printing step while maintaining the pattern shape unchanged. To this end, the conductive circuit-printing ink composition should be selected from those materials capable of minimizing the generation of volatile components for the duration from printing step to the completion of curing step. The ink composition should be prepared substantially without using a solvent.

Curable silicone materials are divided into condensation and addition types in terms of cure mechanism. Silicone-forming materials, specifically silicone rubber-forming materials of the addition type are best suited for the object of the invention because they may be cured without outgassing. In order that a patterning material be cured while maintaining the shape as printed intact, it is preferred that the material be curable under mild conditions of 200°C or below, especially 150°C or below. Silicone-forming materials of the addition type readily meet this requirement.

As to the combination of an addition type silicone precursor with a curing catalyst, numerous materials are known in the art as described in Patent Document 3, for example. Basically, any well-known materials may be used herein. The material which is most preferred as the addition type silicone precursor is a mixture of an organopolysiloxane containing at least two silicon-bonded alkenyl groups and an organohydrogenpolysiloxane containing at least two silicon-bonded hydrogen atoms. They are described in detail below.

### A) Organopolysiloxane containing at least two alkenyl groups

The organopolysiloxane containing at least two alkenyl groups is represented by the average compositional formula (1):

RₐR^{'}_{b}SiO_{(4-a-b)/2} (1)

wherein R is alkenyl, R' is a substituted or unsubstituted monovalent hydrocarbon group of 1 to 10 carbon atoms free of aliphatic unsaturation, a and b are numbers in the range: 0 < a ≤ 2, 0 < b < 3 , and 0 < a+b ≤ 3.

The alkenyl-containing organopolysiloxane serves as component (A) or a base polymer in the composition. This organopolysiloxane contains on average at least 2 (typically 2 to about 50), preferably 2 to about 20, and more preferably 2 to about 10 silicon-bonded alkenyl groups per molecule. Exemplary of the alkenyl group R are vinyl, allyl, butenyl, pentenyl, hexenyl and heptenyl, with vinyl being most preferred. The alkenyl groups are attached to the organopolysiloxane at the ends and/or side chains of its molecular chain.

The organopolysiloxane as component (A) contains a silicon-bonded organic group R' other than alkenyl. Examples of the organic group R' include alkyl groups such as methyl, ethyl, propyl, butyl, pentyl, hexyl and heptyl; aryl groups such as phenyl, tolyl, xylyl, and naphthyl; aralkyl groups such as benzyl and phenethyl; and haloalkyl groups such as chloromethyl, 3-chloropropyl, and 3,3,3-trifluoropropyl. Inter alia, methyl and phenyl are preferred.

The organopolysiloxane as component (A) has a molecular structure which may be linear, partially branched linear, cyclic, branched or three-dimensional network. The preferred organopolysiloxane is a linear diorganopolysiloxane having a backbone consisting of recurring diorganosiloxane units (D units) and capped with triorganosiloxy groups at both ends of the molecular chain, or a mixture of a linear diorganopolysiloxane and a branched or three-dimensional network organopolysiloxane.

The resinous (branched or three-dimensional network) organopolysiloxane is not particularly limited as long as it is an organopolysiloxane comprising alkenyl groups and SiO_{4/2} units (Q units) and/or R"SiO_{3/2} units (T units) wherein R" is R or R'. Examples include a resinous organopolysiloxane consisting of Q units (SiO_{4/2} units) and M units (RR'2SiO_{1/2} units or R'₃SiO_{1/2} units) in a M/Q molar ratio of 0.6 to 1.2, and a resinous organopolysiloxane consisting of T units and M and/or D units. In the practice of the invention, the resinous organopolysiloxane is not added in large amounts because the composition containing a resinous organopolysiloxane may have a higher viscosity enough to prevent heavy loading of conductive powder. Preferably the linear diorganopolysiloxane and the resinous organopolysiloxane are mixed in a weight ratio between 70:30 and 100:0, more preferably between 80:20 and 100:0.

The subscripts a and b are numbers in the range: 0 < a ≤ 2, preferably 0.001 ≤ a ≤ 1, 0 < b < 3, preferably 0.5 ≤ b ≤ 2.5, and 0 < a+b ≤ 3, preferably 0.5 ≤ a+b ≤ 2.7.

The organopolysiloxane as component (A) has a viscosity at 25°C in the range of preferably 100 to 5,000 mPa·s, more preferably 100 to 1,000 mPa·s because the resulting composition is easy to handle and work and the resulting silicone rubber has favorable physical properties. When a linear organopolysiloxane and a resinous organopolysiloxane are used in admixture, a homogeneous mixture should preferably have a viscosity in the range. Since the resinous organopolysiloxane dissolves in the linear organopolysiloxane, they may be mixed into a homogeneous mixture. Notably, the viscosity is measured by a rotational viscometer.

Examples of the organopolysiloxane as component (A) include, but are not limited to, trimethylsiloxy-endcapped dimethylsiloxane/methylvinylsiloxane copolymers, trimethylsiloxy-endcapped methylvinylpolysiloxane, trimethylsiloxy-endcapped dimethylsiloxane/methylvinylsiloxane/methylphenylsiloxane copolymers, dimethylvinylsiloxy-endcapped dimethylpolysiloxane, dimethylvinylsiloxy-endcapped methylvinylpolysiloxane, dimethylvinylsiloxy-endcapped dimethylsiloxane/methylvinylsiloxane copolymers, dimethylvinylsiloxy-endcapped dimethylsiloxane/methylvinylsiloxane/methylphenylsiloxane copolymers, trivinylsiloxy-endcapped dimethylpolysiloxane, organosiloxane copolymers consisting of siloxane units of the formula: R¹₃SiO_{0.5}, siloxane units of the formula: R¹₂R²SiO_{0.5}, siloxane units of the formula: R¹₂SiO, and siloxane units of the formula: SiO₂, organosiloxane copolymers consisting of siloxane units of the formula: R¹₃SiO_{0.5}, siloxane units of the formula: R¹₂R²SiO_{0.5}, and siloxane units of the formula: SiO₂, organosiloxane copolymers consisting of siloxane units of the formula: R¹₂R²SiO_{0.5}, siloxane units of the formula: R¹₂SiO, and siloxane units of the formula: SiO₂, organosiloxane copolymers consisting of siloxane units of the formula: R¹R²SiO, siloxane units of the formula: R¹SiO_{1.5}, and siloxane units of the formula: R²SiO_{1.5}, and mixtures of two or more of the foregoing. As used herein and throughout the disclosure, the term "endcapped" means that a compound is capped at both ends with the indicated group unless otherwise stated.

In the above formulae, R¹ is a monovalent hydrocarbon group other than alkenyl, examples of which include alkyl groups such as methyl, ethyl, propyl, butyl, pentyl, hexyl and heptyl; aryl groups such as phenyl, tolyl, xylyl, and naphthyl; aralkyl groups such as benzyl and phenethyl; and haloalkyl groups such as chloromethyl, 3-chloropropyl, and 3,3,3-trifluoropropyl. R² is an alkenyl group such as vinyl, allyl, butenyl, pentenyl, hexenyl or heptenyl.

### B) Organohydrogenpolysiloxane containing at least two hydrogen atoms

The organohydrogenpolysiloxane containing at least two silicon-bonded hydrogen atoms serving as component (B) contains at least 2 (typically 2 to about 300), preferably at least 3 (typically 3 to about 150), and more preferably 3 to about 100 silicon-bonded hydrogen atoms, i.e., SiH groups per molecule. It may be linear, branched, cyclic or three-dimensional network (or resinous). The organohydrogenpolysiloxane preferably has the average compositional formula (2):

H_{c}R³_{d}SiO_{(4-c-d)/2} (2)

wherein R³ is each independently a substituted or unsubstituted monovalent hydrocarbon group free of aliphatic unsaturation or an alkoxy group, c and d are numbers in the range: 0 < c < 2, 0.8 ≤ d ≤ 2, and 0.8 < c+d ≤ 3. Preferably, c and d are numbers in the range: 0.05 ≤ c ≤ 1, 1.5 ≤ d ≤ 2, and 1.8 ≤ c+d ≤ 2.7. The number of silicon atoms per molecule or the degree of polymerization is preferably 2 to 100, more preferably 3 to 50.

Examples of the monovalent hydrocarbon group free of aliphatic unsaturation, represented by R³, include the same groups as exemplified for R', and suitable alkoxy groups include methoxy and ethoxy. The preferred hydrocarbon groups are free of aromatic groups such as phenyl. Typically R³ is selected from monovalent hydrocarbon groups of 1 to 10 carbon atoms, more preferably 1 to 7 carbon atoms, and specifically lower alkyl groups of 1 to 3 carbon atoms such as methyl, 3,3,3-trifluoropropyl, and alkoxy groups of 1 to 4 carbon atoms. Most preferably R³ is methyl, methoxy or ethoxy.

Examples of the organohydrogenpolysiloxane include, but are not limited to, siloxane oligomers such as 1,1,3,3-tetramethyldisiloxane, 1,3,5,7-tetramethyltetracyclosiloxane, 1,3,5,7,8-pentamethylpentacyclosiloxane, methylhydrogencyclopolysiloxane, methylhydrogensiloxane/dimethylsiloxane cyclic copolymers, and tris(dimethylhydrogensiloxy)methylsilane; trimethylsiloxy-endcapped methylhydrogenpolysiloxane, trimethylsiloxy-endcapped dimethylsiloxane/methylhydrogensiloxane copolymers, silanol-endcapped methylhydrogenpolysiloxane, silanol-endcapped dimethylsiloxane/methylhydrogensiloxane copolymers, dimethylhydrogensiloxy-endcapped dimethylpolysiloxane, dimethylhydrogensiloxy-endcapped methylhydrogenpolysiloxane, and dimethylhydrogensiloxy-endcapped dimethylsiloxane/methylhydrogensiloxane copolymers; and silicone resins comprising R³₂(H)SiO_{1/2} units, SiO_{4/2} units, and optionally R³₃SiO_{1/2} units, R³₂SiO_{2/2} units, R³(H)SiO_{2/2} units , (H)SiO_{3/2} units or R³SiO_{3/2} units wherein R³ is as defined above. Also included are substituted forms of the above illustrated compounds in which some or all methyl is replaced by alkyl (such as ethyl or propyl) as well as the compounds shown below. 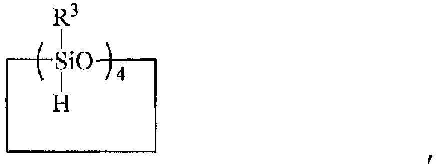 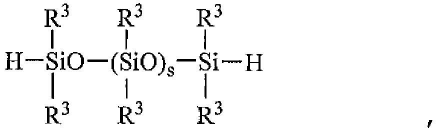 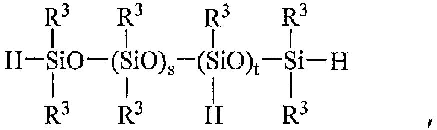 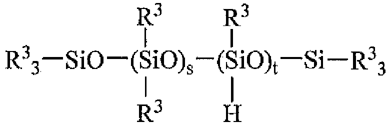 Herein R³ is as defined above, s and t each are 0 or an integer of at least 1.

The organohydrogenpolysiloxane used herein may be prepared by any known methods. For example, it may be obtained from (co)hydrolysis of at least one chlorosilane selected from R³SiHCl₂ and R³₂SiHCl (wherein R³ is as defined above) or cohydrolysis of the chlorosilane in admixture with at least one chlorosilane selected from R³₃SiCl and R³₂SiCl₂ (wherein R³ is as defined above), followed by condensation. The polysiloxane obtained from (co)hydrolysis and condensation may be equilibrated into a product, which is also useful as the organohydrogenpolysiloxane.

Component (B) is preferably used in such amounts as to give 0.5 to 5.0 moles, more preferably 0.7 to 3.0 moles of silicon-bonded hydrogen per mole of silicon-bonded alkenyl groups in component (A). Outside the range, the cured product having sufficient strength may not be obtained because of unbalanced crosslinking.

### C) Conductive particles

The conductive circuit-forming ink composition contains (C) conductive particles. The conductive particles as component (C) include metal particles such as gold, silver and copper particles, and metallized particles such as gold-plated particles, silver-plated particles, and copper-plated particles. Inter alia, gold particles, silver particles, copper particles, and silver-plated plastic particles are preferred for high conductivity.

The conductive particles as component (C) should preferably have an average particle size of 5 to 50 microns (µm). Inclusion of coarse particles having a size in excess of 50 µm is not preferable because coarse particles may clog openings of a printing screen. As used herein, the average particle size (sometimes simply size) is determined as a weight average value D50 in particle size distribution measurement by the laser light diffraction method.

In a preferred embodiment, the conductive particles as component (C) are composed mainly of particles having an average particle size of at least 5 µm, preferably 5 to 20 µm, selected from among metal particles, gold-plated particles, silver-plated particles, and copper-plated particles, and micro-particles having an average particle size of less than 5 µm, preferably less than 1 µm, selected from among metal particles, gold-plated particles, silver-plated particles, and copper-plated particles, may be contained in an amount of at least 1 part by volume per 100 parts by volume of component (A).

As long as the average particle size of main conductive particles is equal to or more than 5 µm, their influence on the thixotropy of the ink composition is limitative. Thus the amount of conductive particles loaded may be determined while taking into account only the resistivity. On the other hand, the addition of conductive micro-particles having an average particle size of less than 5 µm causes only a little change in bulk resistivity and mainly contributes to a reduction of contact resistance at the interface.

The amount of main conductive particles with size ≥ 5 µm loaded should preferably be 40 to 120 parts, and even more preferably 50 to 100 parts by volume per 100 parts by volume of component (A). If the amount of conductive particles with size ≥ 5 µm is less than 40 parts by volume, the resulting silicone rubber may have a low conductivity. If the amount of conductive particles with size ≥ 5 µm exceeds 120 parts by volume, the resulting composition may become difficult to handle.

The amount of conductive micro-particles with size < 5 µm loaded should preferably be 1 to 20 parts, more preferably 2 to 10 parts by volume per 100 parts by volume of component (A). If the amount of micro-particles with size < 5 µm is less than 1 part by volume, it may be insufficient to contribute to a reduction of contact resistance. If the amount of micro-particles with size < 5 µm exceeds 20 parts by volume, it may adversely affect the thixotropy and viscosity of the ink composition, which becomes ineffective in printing. Since micro-particles with size < 5 µm are, in most cases, more expensive than conductive particles with size ≥ 5 µm, it is recommended from the economical aspect to achieve an improvement in contact resistance with a minimal amount of conductive micro-particles added. Since the addition of such micro-particles is accompanied by a buildup of thixotropy and viscosity of the ink composition, the addition amount is restricted in terms of printability. For the purpose of reducing contact resistance, the amount of micro-particles added may be up to 10 parts by volume per 100 parts by volume of component (A) and typically equal to or less than the amount of carbon black added as the thixotropic agent. It is preferred for circuit shape stabilization that the composition is tailored optimum by adding an additional thixotropic agent.

The conductive particles with size ≥ 5 µm and the conductive micro-particles with size < 5 µm need not necessarily be of the same type. For example, to the composition loaded with silver-plated plastic particles with size ≥ 5 µm, silver nano-particles may be added as the micro-particles with size < 5 µm.

### D) Thixotropic agent

A thixotropic agent (D) is contained in the conductive circuit-forming ink composition. It imparts thixotropy to the ink composition and ensures that the printed pattern maintains its shape from the printing step to the curing step. The thixotropic agent is selected from among carbon black, zinc white, tin oxide, tin-antimony oxide, and silicon carbide (SiC) having a medium electrical resistance, with carbon black being most preferred.

When a pattern having a steric shape is printed using an ink composition, the ink composition must have thixotropy in order to maintain the shape of the ink pattern as printed until the pattern is heat cured. For enhancing the thixotropy of a material having a sufficient fluidity to print, it is a common practice to add a thixotropic agent thereto. The inventor first attempted to add dry silica as the thixotropy enhancer. It was empirically found that as the amount of silica added is increased, the composition increases not only thixotropy, but also electrical resistance. The attempt failed to formulate a composition meeting both thixotropy and conductivity. With an intention to improve conductivity, the inventor then attempted to add carbon black having a medium value of electrical resistance. Surprisingly, it was found that as the amount of carbon black added is increased, thixotropy increases, and electrical resistance remains unchanged or rather decreases. While conductive silicone compositions having carbon black added thereto are widely known in the art, they mostly have a resistivity of about 1 Ω·cm, which corresponds to an extremely low level of conductivity as compared with the conductivity in a range of 1×10⁻² to 1×10⁻⁵ Ω·cm as intended herein. Although the reason why the addition of a thixotropic agent having a medium value of electrical resistance, typically carbon black lowers the electrical resistance of a conductive particle-loaded ink composition is not well understood, the use of a thixotropic agent having a medium value of electrical resistance enables to control thixotropy independent of conductivity.

Any carbon black species commonly used in conductive rubber compositions may be used as the thixotropic agent. Examples include acetylene black, conductive furnace black (CF), super-conductive furnace black (SCF), extra-conductive furnace black (XCF), conductive channel black (CC), as well as furnace black and channel black which have been heat treated at high temperatures of 1,500°C to 3,000°C. Of these, acetylene black is most preferred in the practice of the invention because it has a high conductivity due to a low impurity content and fully developed secondary structure.

Component (D) is preferably used in an amount of 0.5 to 30 parts, more preferably 1 to 20 parts by weight per 100 parts by weight of component (A). Less than 0.5 parts by weight of component (D) may provide poor shape retention whereas a composition containing more than 30 parts by weight of component (D) may have too high a viscosity to handle.

### E) Hydrosilylation catalyst

The addition or hydrosilylation reaction catalyst is a catalyst for promoting addition reaction between alkenyl groups in component (A) and silicon-bonded hydrogen atoms (i.e., SiH groups) in component (B). For hydrosilylation reaction, any well-known catalysts such as platinum group metal based catalysts may be used.

Any well-known platinum group metal based catalysts may be used as the hydrosilylation catalyst. Examples include platinum group metals alone such as platinum black, rhodium, and palladium; platinum chloride, chloroplatinic acid and chloroplatinic acid salts such as H₂PtCl₄·yH₂O, H₂PtCl₆·yH₂O, NaHPtCl₆·yH₂O, KHPtCl₆·yH₂O, Na₂PtCl₆·yH₂O, K₂PtCl₄·yH₂O, PtCl₄·yH₂O, EtCl₂, and Na₂HPtCl₄·yH₂O wherein y is an integer of 0 to 6, preferably 0 or 6; alcohol-modified chloroplatinic acid (USP 3220972); chloroplatinic acid-olefin complexes (USP 3159601, 3159662, and 3775452); platinum group metals such as platinum black and palladium on supports such as alumina, silica and carbon; rhodium-olefin complexes; chlorotris(triphenylphosphine)rhodium (Wilkinson catalyst); and complexes of platinum chloride, chloroplatinic acid and chloroplatinic acid salts with vinyl-containing siloxanes, especially vinyl-containing cyclosiloxanes. Of these, from the standpoints of compatibility and chloride impurity, preference is given to silicone-modified chloroplatinic acid, specifically a platinum catalyst obtained by modifying chloroplatinic acid with tetramethyldivinyldisiloxane.

Component (E) is preferably added in such amounts as to give 1 to 500 ppm, more preferably 3 to 100 ppm, and even more preferably 5 to 80 ppm of platinum atom based on the total weight of the ink composition components.

Preferably, the conductive ink composition may further comprise a stabilizer and a tackifier.

### Stabilizer

Preferably a stabilizer is added to the conductive circuit-forming ink composition so that the composition may undergo consistent addition cure. Suitable stabilizers include fatty acids and acetylene compounds. More preferably, fatty acids, fatty acid derivatives, and/or metal salts thereof are added. When fatty acids, fatty acid derivatives, and/or metal salts thereof are used as the stabilizer, the amount of the stabilizer added is preferably 0.1 to 10 parts, more preferably 0.1 to 5 parts by weight per 100 parts by weight of component (A). Less than 0.1 pbw of the stabilizer may fail to ensure a consistent curing behavior after shelf storage whereas more than 10 pbw may adversely affect the addition curability. The preferred fatty acids, fatty acid derivatives, and metal salts thereof are of at least 8 carbon atoms.

Suitable fatty acids include caprylic acid, undecylenic acid, lauric acid, myristic acid, palmitic acid, margaric acid, stearic acid, arachic acid, lignoceric acid, cerotic acid, melissic acid, myristoleic acid, oleic acid, linoleic acid, and linolenic acid.

Suitable fatty acid derivatives include fatty acid esters and aliphatic alcohol esters. Suitable fatty acid esters include polyhydric alcohol esters such as esters of the foregoing fatty acids with C₁-C₅ lower alcohols, sorbitan esters, and glycerol esters. Suitable aliphatic alcohol esters include esters of saturated alcohols such as octyl alcohol, lauryl alcohol, myristyl alcohol, and stearyl alcohol, with fatty acids including dibasic acids such as glutaric acid and suberic acid, and tribasic acids such as citric acid.

Suitable fatty acid metal salts include metal salts such as lithium, calcium, magnesium and zinc salts of fatty acids such as caprylic acid, undecylenic acid, lauric acid, myristic acid, palmitic acid, margaric acid, stearic acid, arachic acid, lignoceric acid, cerotic acid, melissic acid, myristoleic acid, oleic acid, linoleic acid, and linolenic acid.

Inter alia, stearic acid and salts thereof are most preferred as the stabilizer. The stabilizer may be added alone or as a premix with the hydrosilylation reaction catalyst.

### Tackifier

The tackifier is added to the ink composition for rendering it more self-adhesive to the substrate. Suitable tackifiers are compounds having an epoxy and/or alkoxysilyl group. When used, the tackifier is preferably added in an amount of 0.5 to 20 parts, more preferably 1 to 10 parts by weight per 100 parts by weight of component (A). Less than 0.5 pbw of the tackifier is ineffective for impacting adhesion. More than 20 pbw of the tackifier may adversely affect the shelf stability of the composition, allow the hardness of the cured composition to change with time, and sometimes, cause a change of the pattern shape due to outgassing, depending on certain components.

It is noted that when a tackifier having a silicon-bonded hydrogen atom (i.e., SiH group) is used, it is preferably added in such amounts that 0.5 to 5.0 moles, more preferably 0.7 to 3.0 moles of SiH groups in component (B) plus the tackifier may be available per mole of alkenyl groups in component (A).

Exemplary tackifiers are given below.

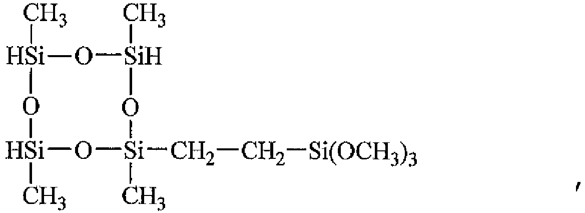

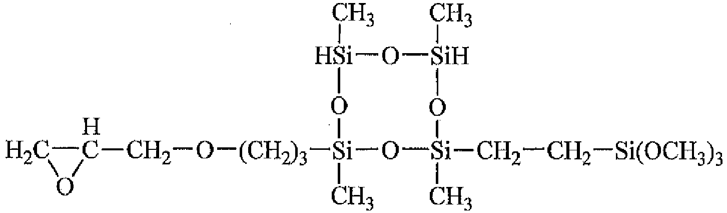

Besides the foregoing components, any other additives may be added to the conductive ink composition if desired. In particular, a hydrosilylation reaction retarder may be added for the purpose of enhancing storage stability. The reaction retarder may be selected from well-known ones, for example, acetylene compounds, compounds containing at least two alkenyl groups, alkynyl-containing compounds, triallyl isocyanurate and modified products thereof. Inter alia, the alkenyl and alkynyl-containing compounds are desirably used. The reaction retarder is desirably added in an amount of 0.05 to 0.5 part by weight per the total weight (=100 parts by weight) of other components in the ink composition. Outside the range, a less amount of the retarder may be ineffective in retarding hydrosilylation reaction whereas an excess of the retarder may interfere with the cure process.

The ink composition may be prepared, for example, by mixing the foregoing components on a mixer such as planetary mixer, kneader or Shinagawa mixer.

The ink composition has a viscosity and thixotropy index, which are important factors in forming conductive circuits according to the invention. Preferably the ink composition has a viscosity at 25°C of 10 to 200 Pa·s, more preferably 20 to 100 Pa·s, as measured by HAAKE RotoVisco 1 (Thermo Scientific) at a rotational speed of 10 radian/sec. An ink composition having a viscosity of less than 10 Pa·s may flow and fail to retain the shape when the composition is dispensed or otherwise applied or when heat cured. An ink composition having a viscosity of more than 200 Pa·s may fail to follow the mask pattern faithfully when dispensed, leaving defects in the pattern. The thixotropy index, which is defined as the ratio of the viscosity at a shear rate of 0.5 radian/sec to the viscosity at 10 radian/sec of the composition at 25°C, is preferably at least 1.1, and more preferably 1.5 to 5.0. A composition having a thixotropy index of less than 1.1 may be difficult to stabilize the shape as applied.

The ink composition for use in the conductive circuit-forming method is substantially free of a solvent. When a hydrosilylation reaction catalyst is prepared, a slight amount of solvent may be carried over in the catalyst. Even in such a case, the amount of solvent should preferably be less than 0.1% by weight of the overall composition.

By virtue of the substantial absence of solvents, the ink composition whose viscosity and thixotropy have been adjusted as above has such physical properties that when a pattern of dots shaped to have a diameter of 0.8 mm and a height of 0.4 mm is printed and heat cured at 80 to 200°C, the dot shape may experience a change of height within 5% on comparison between the shape as printed and the shape as cured. That is, a height change of the dot shape before and after curing is within 5%. The shape retaining ability of an ink composition can be evaluated by comparing the shape as printed with the shape as cured in this way. The shape to be compared is not limited to the dot shape, and a line shape may be used instead. The dot shape is preferably adopted herein because the dot shape follows a sharp change depending on the shape retaining ability. Values of shape change may be measured by various optical procedures. For example, measurement may be carried out by using a confocal laser microscope, determining the pattern shape as printed prior to cure and the pattern shape as cured, and comparing the maximum height of the pattern relative to the substrate. The composition which is to pass the test does not show a substantial change of the pattern shape even when the holding time from pattern formation by printing to heat curing is varied. For the composition which is to fail the test, the holding time from pattern formation by printing to heat curing may be set arbitrary because this composition undergoes a shape change during the curing step.

### Method for manufacturing conductive circuit

Referring to the figures, several embodiments of the method for manufacturing a conductive circuit according to the invention are described.

### Embodiment 1 not of the invention

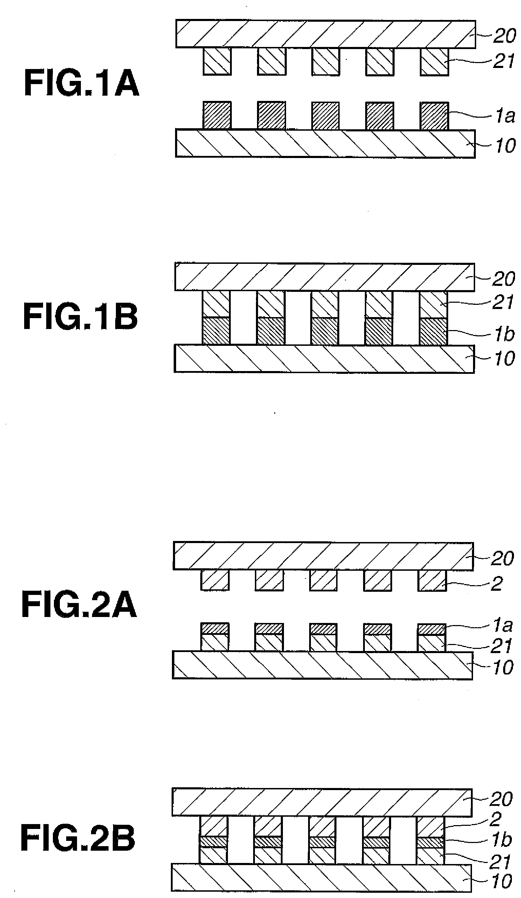

In a first embodiment, as shown in FIG. 1, the ink composition defined above is printed on a first substrate 10 to form a green circuit pattern 1a of predetermined configuration. The green circuit pattern 1a is placed in contact with a patterned metal electrode 21 on a second substrate 20. The green circuit pattern 1a in contact with the metal electrode 21 is fired and cured to form a cured circuit pattern 1b and to bond the pattern 1b to the metal electrode 21. In this way, a conductive circuit consisting of the cured circuit pattern 1b and the metal electrode 21 is completed, and the first and second substrates 10 and 20 bonded together.

### Embodiment 2 not of the invention

In a second embodiment, as shown in FIG. 2, the ink composition is printed on a patterned metal electrode 21 on a first substrate 10 to form a green circuit pattern 1a of predetermined configuration. Separately, there is furnished a second substrate 20 having a cured circuit pattern 2 which has been previously formed by printing, firing and curing a circuit pattern of conformable configuration to the green circuit pattern 1a. The green circuit pattern 1a is placed in contact with the cured conductive circuit pattern 2 on the second substrate 20. The green circuit pattern 1a in contact with the cured conductive circuit pattern 2 is fired and cured to form a cured circuit pattern 1b and to bond the circuit patterns 1b and 2 together. In this way, a conductive circuit consisting of the cured circuit patterns 1b, 2 and the metal electrode 21 is completed, and the first and second substrates 10 and 20 bonded together.

It is noted that the cured circuit pattern 2 on the second substrate 20 is preferably formed of the ink composition defined herein, but it may be formed of any well-known conductive circuit-imaging ink composition. In the second embodiment, as long as the cured conductive circuit pattern 2 on the second substrate 20 is adjusted in height, the thickness of the circuit pattern 1a printed on the metal electrode 21 may be a minimum necessary for bonding.

### Embodiment 3 not of the invention

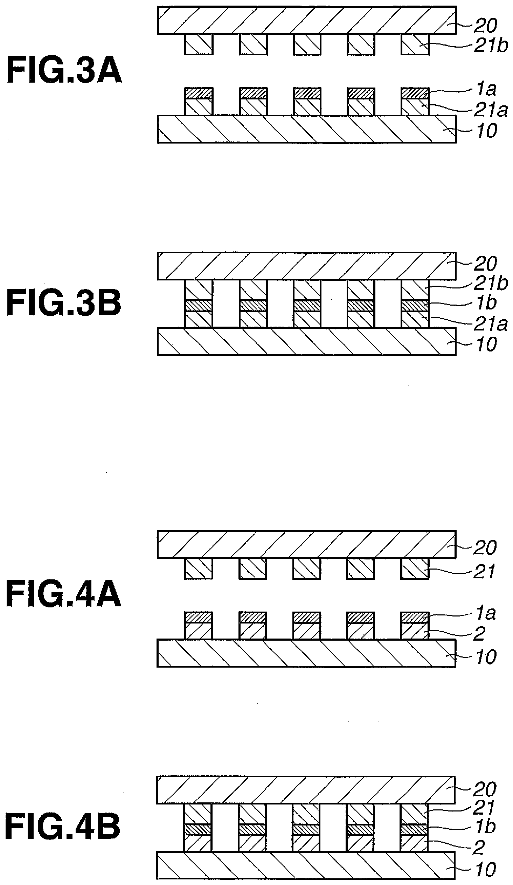

In a third embodiment, as shown in FIG. 3, the ink composition is printed on a patterned metal electrode 21a on a first substrate 10 to form a green circuit pattern 1a of predetermined configuration. Separately, a second substrate 20 having a patterned metal electrode 21b formed thereon is furnished. The green circuit pattern 1a is placed in contact with the metal electrode 21b on the second substrate 20. The green circuit pattern 1a in contact with the metal electrode 21b is fired and cured to form a cured circuit pattern 1b and to bond the circuit pattern 1b to the metal electrode 21b. In this way, a conductive circuit consisting of the metal electrode 21a, cured circuit pattern 1b, and metal electrode 21b is completed, and the first and second substrates 10 and 20 bonded together.

It is noted that the metal electrodes 21a and 21b may be of the same metal or different metals. In the third embodiment, as long as the metal electrodes 21a and 21b are adjusted in height, the thickness of the pattern 1a printed on the metal electrode 21a may be a minimum necessary for bonding.

### Embodiment 4 not of the invention

In a fourth embodiment, as shown in FIG. 4, there is furnished a first substrate 10 having a cured conductive circuit pattern 2 which has been previously formed by printing, firing and curing a circuit pattern of predetermined configuration on the first substrate 10. The ink composition is printed on the cured conductive circuit pattern 2 to form a green circuit pattern 1a of predetermined configuration. The green circuit pattern 1a is placed in contact with a patterned metal electrode 21 on a second substrate 20. The green circuit pattern 1a in contact with the metal electrode 21 is fired and cured to form a cured circuit pattern 1b and to bond the pattern 1b to the metal electrode 21. In this way, a conductive circuit consisting of the cured circuit patterns 2 and 1b and the metal electrode 21 is completed, and the first and second substrates 10 and 20 bonded together.

Although it is preferred for effective bonding that the cured circuit pattern 2 on the first substrate 10 be formed of the ink composition defined herein, it may be formed of any well-known conductive circuit-imaging ink composition. In the fourth embodiment, as long as the metal electrode on the second substrate is adjusted in height, the thickness of the pattern 1a printed on the cured circuit pattern 2 may be a minimum necessary for bonding.

### Embodiment 5 not of the invention

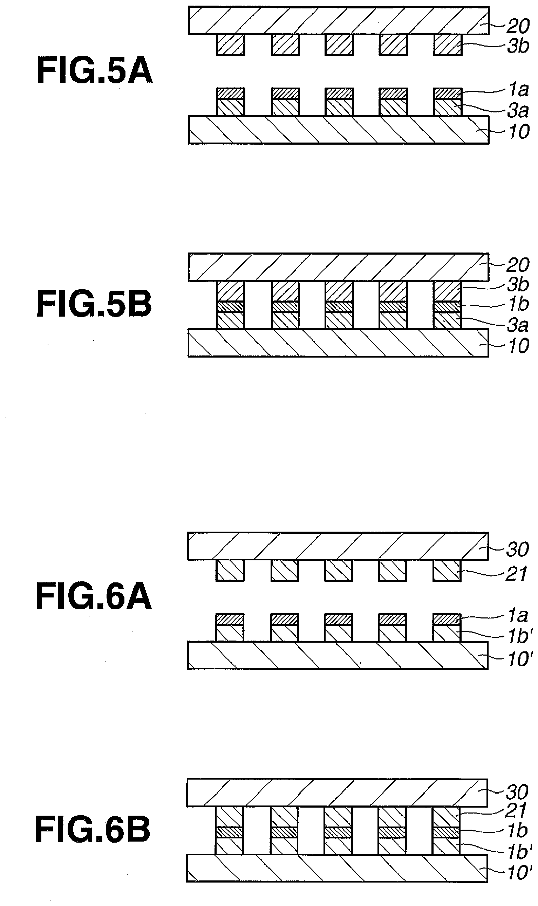

In a fifth embodiment, as shown in FIG. 5, there is furnished a first substrate 10 having a cured conductive circuit pattern 3a which has been previously formed by printing, firing and curing a circuit pattern of predetermined configuration on the first substrate 10. The ink composition is printed on the cured conductive circuit pattern 3a to form a green circuit pattern 1a of predetermined configuration. Separately, there is furnished a second substrate 20 having a cured conductive circuit pattern 3b which has been previously formed by printing, firing and curing a circuit pattern of conformable configuration to the green circuit pattern 1a, on the second substrate 20. The green circuit pattern 1a is placed in contact with the cured circuit pattern 3b. The green circuit pattern 1a in contact with the circuit pattern 3b is fired and cured to form a cured circuit pattern 1b and to bond the circuit patterns 1b and 3b together. In this way, a conductive circuit consisting of the circuit patterns 3a, 1b and 3b is completed, and the first and second substrates 10 and 20 bonded together.

It is noted that the cured circuit patterns 3a and 3b are preferably formed of the ink composition defined herein, but they may be formed of another conductive circuits-imagine ink composition. In the fifth embodiment, as long as the cured conductive circuit patterns 3a and 3b on the first and second substrates are adjusted in height, the thickness of the pattern 1a printed on the pattern 3a may be a minimum necessary for bonding.

The substrates used herein include substrates of silicon, epoxy resins, phenolic resins, polytetrafluoroethylene (typically Teflon®), polyimide resins, and ceramics, and such substrates having a metal layer evaporated or attached thereto. The first and second substrates may be the same or different.

The printing technique used in the conductive circuit-forming method is not particularly limited as long as the amount of the ink composition applied can be controlled at a high accuracy. The preferred printing techniques are dispense printing and screen printing. The screen printing technique capable of high accuracy control is more preferred. As long as the viscosity and thixotropy of the ink composition are adjusted in accordance with the mask shape used in printing, the screen printing technique may comply with a pattern size in the range from several tens of microns to several hundreds of microns (µm).

According to the method, a conductive circuit is formed by printing a circuit pattern using an ink composition as defined herein and curing the pattern. To complete the conductive circuit pattern while maintaining the shape as printed intact, the pattern is cured under appropriate conditions, preferably at 100 to 200° C for 1 to 120 minutes. In the curing step, any of well-known heating devices such as hot plate and oven may be selected in accordance with the substrate used.

In the first embodiment, the cured circuit pattern 1b preferably has a thickness of 10 to 500 µm, more preferably 50 to 200 µm. In the second to fifth embodiments, the cured circuit pattern 1b preferably has a thickness of 5 to 200 µm, more preferably 20 to 50 µm.

The metal electrode may be made of copper, silver, gold, solder, nickel or the like, with the solder being preferred. The term "solder" refers to a tin-based, lead-free alloy having a melting point of up to 250°C. The thickness of the metal electrode may be selected as appropriate although the electrode thickness is preferably in a range of 10 to 500 µm, more preferably 50 to 200 µm.

Also, the thickness of the cured conductive circuit pattern previously formed on the substrate may be selected as appropriate although the pattern thickness is preferably in a range of 10 to 500 µm, more preferably 50 to 200 µm.

In the event that the conductive circuit thus formed becomes defective, a solder electrode which is used as the metal electrode is heated and melted, whereupon the cured circuit pattern which has been bonded to the solder electrode is recovered for reworking. In this context, the following embodiments are encompassed within the invention.

### Embodiment 6

In a sixth embodiment, a solder electrode is used as the metal electrode to be bonded so that the once formed joint may be reworked by the conventional solder joint rework process. In a structure wherein a cured circuit pattern formed by firing and curing a green circuit pattern is bonded to a solder electrode, for example, the structure of the above-mentioned embodiment wherein the cured circuit pattern, which is formed by firing and curing a green circuit pattern on a first substrate kept in contact with a solder electrode as the metal electrode on a second substrate, is bonded to the solder electrode, the solder electrode is heated and melted, allowing the cured circuit pattern to be separated from the solder electrode. Thus the first substrate having the cured circuit pattern is recovered for rework.

### Embodiment 7

As shown in FIG. 6, a seventh embodiment starts with the substrate 10' recovered by the rework process of the sixth embodiment, without removing the cured circuit pattern 1b' used for bonding. The ink composition defined above is printed on the substrate 10' to form a green circuit pattern 1a of predetermined configuration thereon. The green circuit pattern 1a is placed in contact with a metal electrode 21 (typically solder electrode) formed on another substrate 30. The green circuit pattern 1a in contact with the metal electrode 21 is fired and cured to form a cured circuit pattern 1b for bonding the pattern 1b to the metal electrode 21. In this way, a conductive circuit consisting of the patterns 1b' and 1b and the metal electrode 21 is completed, and the two substrates 10' and 30 bonded together.

### Embodiment 8

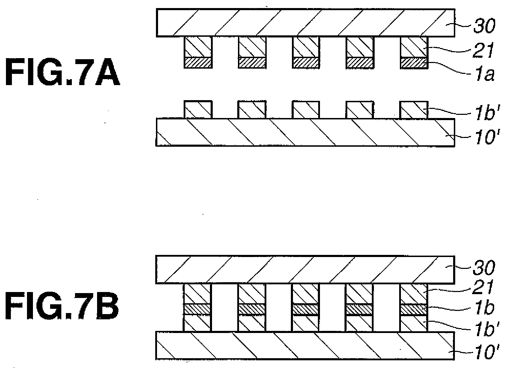

As shown in FIG. 7, an eighth embodiment starts with the substrate 10' recovered by the rework process of the sixth embodiment, without removing the cured circuit pattern 1b' used for bonding. Separately, the ink composition defined above is printed on a metal electrode 21 (typically solder electrode) formed on another substrate 30 to form a green circuit pattern 1a of predetermined configuration thereon. The green circuit pattern 1a is placed in contact with the cured circuit pattern 1b' on the recovered substrate 10'. The green circuit pattern 1a in contact with the cured circuit pattern 1b' is fired and cured to form a cured circuit pattern 1b for bonding the pattern 1b to the pattern 1b'. In this way, a conductive circuit consisting of the metal electrode 21 and the patterns 1b and 1b' is completed, and the two substrates 10' and 30 bonded together.

The conductive circuit-imaging ink composition is thixotropic and effectively printable. The method of the invention ensures that a conductive circuit is formed from the thixotropic ink composition by printing techniques, typically screen printing. The resulting conductive circuit has many advantages including a low ohmic resistance, good shape reproduction, high-speed printing, high throughputs and yields of pattern formation. The circuit as printed retains its shape even during the cure step following printing, leading to high-level control of the circuit shape. Because of the silicone rubber-based structure, the printed circuit has a stress relaxation ability with respect to thermal stress or the like.

Where a solder electrode is used as the counter electrode, the solder bump rework technique may be used as such during the rework step of the process. Namely, if any failure occurs at a junction to the solder electrode, the junction can be released by melting and removing the solder electrode by a combination of local heating and suction, like the solder bump rework technique. At this point, the cured circuit is not degraded at all because the silicone rubber has a heat resistant temperature of at least 250°C, which is higher than the melting temperature of solder in a range of 200° C to 230° C.

The solder after melting has a very low affinity to the surface of the cured silicone rubber composition, it can be removed by the conventional solder suction/removal process with a minimal risk of solder remaining on the cured composition electrode surface. In the re-bonding step, without removing the cured conductive circuit pattern, the conductive circuit pattern electrode after recovery and a solder electrode may be re-bonded via the ink composition defined herein. In this case, the ink composition may be printed either on the conductive circuit pattern electrode or on the solder electrode.

### EXAMPLE

Examples not of the invention are given below by way of illustration. Me stands for methyl.

### Preparation of ink composition

Ink compositions of Examples 1 to 6 and Comparative Example 1 were prepared by mixing amounts of selected components as shown in Table 1 in an axial/planetary motion mixer (HIVIS MIX® Model 2P-03 by Primix Corp.) until uniform. It is noted that the viscosity of the composition is measured at 25°C by HAAKE RotoVisco 1 (Thermo Scientific) at a rotational speed of 10 radian/sec; and the average particle size is a weight average value D50 in particle size distribution measurement by the laser light diffraction method.
(A) Dimethylpolysiloxane containing two silicon-bonded vinyl groups at both ends and having a viscosity of 600 mPa·s at 25° C
(B-1) Trimethylsiloxy-endcapped methylhydrogenpolysiloxane having a viscosity of 5 mPa_{·}s at 25° C and a hydrogen gas release of 350 ml/g [Me₃SiO-(SiHMeO)₄₀-SiMe₃]
(B-2) Alkoxy-containing compound of the following formula (3): 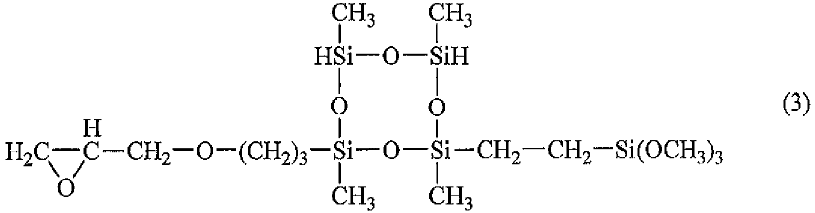
(C-1) Silver-plated phenolic resin powder, average particle size 10 µm (Mitsubishi Materials Corp.)
(C-2) Silver powder AgC-237 (as acetone cleaned and dried), average particle size 7.2 µm (Fukuda Metal Foil and Powder Co., Ltd.)
(D) Denka Black HS-100 (Denki Kagaku Kogyo K.K.)
(E-1) Platinum catalyst derived from chloroplatinic acid and having tetramethylvinyldisiloxane ligand (Pt content 1 wt%)
(E-2) Mixture of (E-1) and stearic acid in a weight ratio of 3/2
   Stabilizer: stearic acid
   Reaction retarder: 1-ethynyl-1-cyclohexanol

### Measurement of volume resistivity (conductivity)

The ink composition prepared above was cast into a frame to a thickness of 1 mm and cured in an oven at 150° C for 1 hour, yielding a cured conductive silicone rubber sheet. The sheet was measured for volume resistivity (conductivity) by the four-terminal method using a DC voltage current source/monitor ADCMT 6241A (ADC Corp.).

### Measurement of resistivity

The ink composition prepared above was screen printed on a solder-plated copper plate to form a pattern of dots having a diameter of 400 µm and a height of 150 µm and cured in an oven at 150° C for 1 hour to form a conductive silicone rubber pattern. The pattern was measured for resistivity by the two-terminal method using a DC voltage current source/monitor ADCMT 6241A (ADC Corp.).

### Shape retention

Shape retention was evaluated using a pattern of dots shaped to have a diameter of 0.8 mm and a height of 0.4 mm. The ink composition was applied to an aluminum substrate through a punched sheet of polytetrafluoroethylene having a thickness of 0.5 mm and an opening diameter of 0.75 mm to form an ink pattern of dots on the substrate. The shape of the ink pattern was observed under a confocal laser microscope VK-9700 (Keyence Corp.). The diameter and the maximum height (relative to the substrate) of dots were measured. Next, the pattern-bearing aluminum substrate was placed in an oven where the dot pattern was cured at 150°C for 1 hour. The maximum height (relative to the substrate) of dots in the cured pattern was measured again using the laser microscope. A ratio (%) of the maximum height of dot pattern as cured to the maximum height of dot pattern prior to cure is reported as shape retention in Table 1.

### Bond strength

The ink composition was printed and cured to a substrate under the conditions to be described below. The sample was measured for bond strength using a bonding tester model PTR-100 (RHESCA Corp., sensor type LV25-5k (1.2 mm wide)) in a shore test mode (method destructive, full scale 5,000 g, speed 0.2 mm/sec, locate 20.0 µm).

### Example 1 not of the invention

The conductive circuit-imaging ink composition in Table 1 was printed on a silicon substrate by the screen printing technique to form a printed circuit pattern layer having a diameter of 400 and a height of 150 µm and cured in an oven at 150°C for 1 hour to form a cured circuit pattern. The bond strength of the cured circuit pattern to the silicon substrate was measured.

### Example 2 not of the invention

The conductive circuit-imaging ink composition in Table 1 was printed on a silicon substrate by the screen printing technique to form a printed circuit pattern layer having a diameter of 400 µm and a height of 150 µm. Separately, a solder pattern of the same configuration as the printed circuit pattern layer was formed on a base plate as an electrode pattern. The printed circuit pattern layer was placed in contact with the solder pattern in an overlapping manner and cured in an oven at 150°C for 1 hour to form a cured circuit pattern. The silicon substrate was stripped from the cured circuit pattern, leaving a joined structure of the cured circuit pattern and the solder pattern. For this sample, the bond strength between the cured circuit pattern and the solder pattern was measured.

### Example 3 not of the invention

The conductive circuit-imaging ink composition in Table 1 was printed on a silicon substrate by the screen printing technique to form a printed circuit pattern layer having a diameter of 400 µm and a height of 150 µm and cured in an oven at 150°C for 1 hour to form a cured circuit pattern. Next, the conductive circuit-imaging ink composition in Table 1 was printed on the cured circuit pattern to form a printed circuit pattern layer of the same configuration and cured in an oven at 150° C for 1 hour to form a cured circuit pattern, yielding a stack of the cured circuit patterns. For this sample, the bond strength between the cured circuit pattern layers was measured.

### Examples 4 to 6 not of the invention

Samples were prepared as in Examples 1 to 3 under the same conditions except that the conductive circuit-imaging ink composition was changed as shown in Table 1. The samples were measured for bond strength.

### Comparative Example 1

The conductive circuit-imaging ink composition in Table 1 was printed on a silicon substrate by the screen printing technique to form a printed circuit pattern layer having a diameter of 400 µm and a height of 150 and cured in an oven at 150° C for 1 hour to form a cured circuit pattern. Separately, a solder pattern of the same configuration as the printed circuit pattern layer was formed on a base plate. The cured circuit pattern was placed in contact with the solder pattern in an overlapping manner. The assembly was heated until the solder was melted, after which the silicon substrate was stripped off. Concomitantly the cured circuit pattern was stripped from the solder pattern.

The measurement results are shown in Table 1. In Example 2, the electrode pattern could be formed from copper, gold, aluminum or another metal instead of solder by the bump forming technique. The same experiment as in Example 2 was carried out by forming electrode patterns of these metals instead of the solder pattern, conforming that a satisfactory bond strength was obtained in each case.

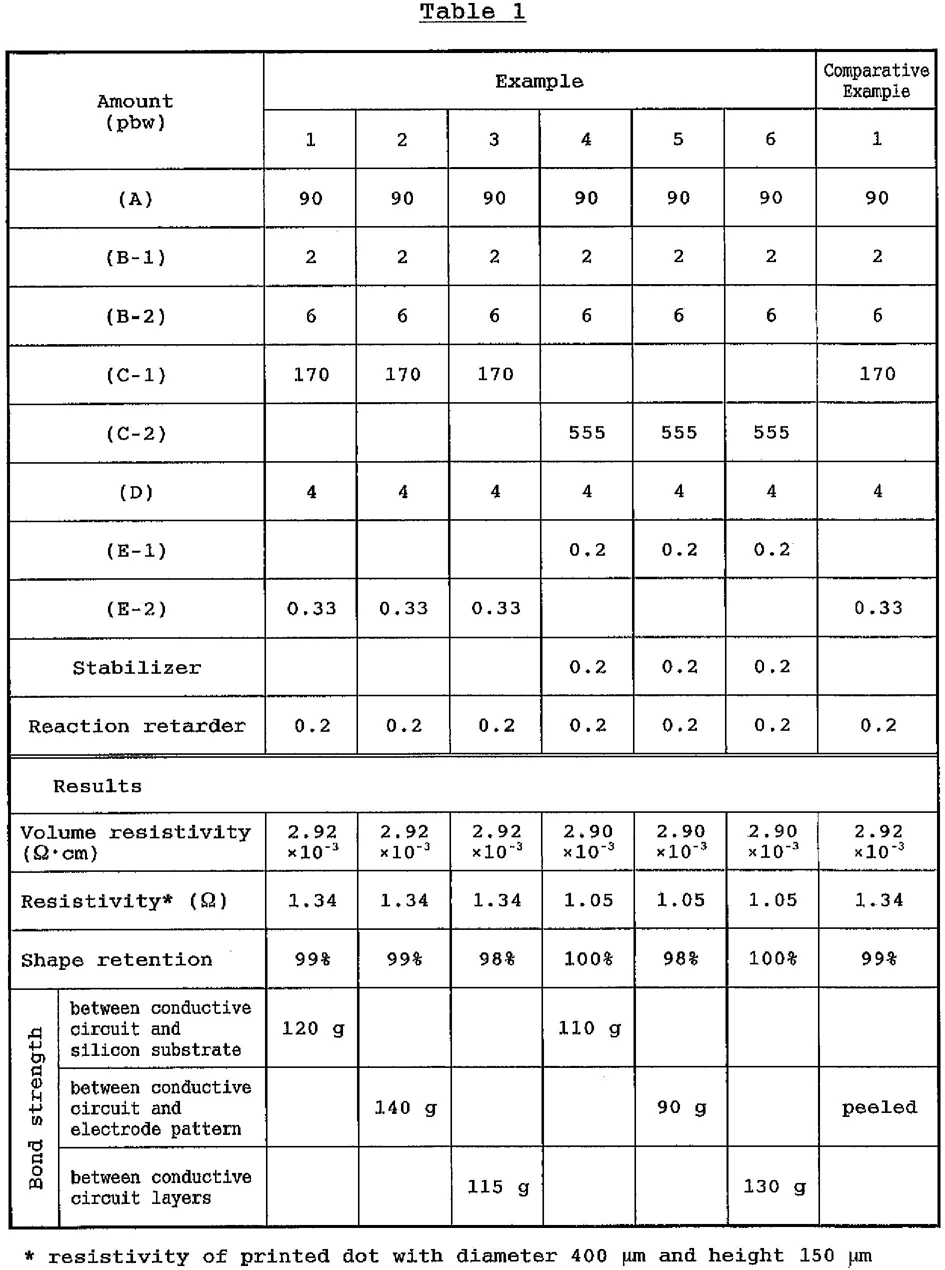

## Claims

1. A method for forming a conductive circuit comprising the steps of:
printing an ink composition on a first substrate to form a green circuit pattern of predetermined configuration,
placing the green circuit pattern in contact with a solder electrode serving as a metal electrode on a second substrate,
firing and curing the green circuit pattern in the contact state for thereby forming a cured conductive circuit pattern, thus yielding a structure wherein the cured circuit pattern is bonded to the solder electrode,
heating to melt the solder electrode, allowing the cured conductive circuit pattern to be separated from the solder electrode, and recovering the first substrate having the cured conductive circuit pattern for rewording,
providing the recovered substrate, without removing the cured circuit pattern used for bonding,
printing the ink composition on the substrate to form a further green circuit pattern of predetermined configuration, and placing the further green circuit pattern in contact with a metal electrode on another substrate, or printing the ink composition on a metal electrode on another substrate to form a further green circuit pattern, and placing the further green circuit pattern in contact with the cured circuit pattern on the substrate recovered by the reworking method,
firing and curing the further green circuit pattern in the contact state for thereby forming a conductive circuit and bonding the substrates together,
said ink composition being a substantially solvent-free, liquid, addition curable, conductive circuit-forming ink composition comprising
(A) an organopolysiloxane having at least two silicon-bonded alkenyl, groups,
(B) an organohydrogenpolysiloxane having at least two silicon-bonded hydrogen atoms,
(C) conductive particles,
(D) a thixotropic agent selected from the group consisting of carbon black, zinc white, tin oxide, tin-antimony oxide, and silicon carbide, and
(E) a hydrosilylation catalyst.

2. The method for forming a conductive circuit according to claim 1, comprising the steps of:
printing the ink composition on a metal electrode on a first substrate to form a green circuit pattern of predetermined configuration,
placing the green circuit pattern in contact with a cured conductive circuit pattern on a second substrate which has been previously formed by printing, firing and curing a circuit pattern of conformable configuration on the second substrate, and
firing and curing the green circuit pattern in the contact state for thereby forming a conductive circuit and bonding the first and second substrates together.

3. The method for forming a conductive circuit according to claim 1, comprising the steps of:
printing the ink composition on a metal electrode on a first substrate to form a green circuit pattern of predetermined configuration,
placing the green circuit pattern in contact with a metal electrode on a second substrate, and
firing and curing the green circuit pattern in the contact state for thereby forming a conductive circuit and bonding the first and second substrates together.

4. The method for forming a conductive circuit according to claim 1, comprising the steps of:
printing the ink composition on a cured conductive circuit pattern on a first substrate which has been previously formed by printing, firing and curing a circuit pattern of predetermined configuration on the first substrate, to form a green circuit pattern of predetermined configuration,
placing the green circuit pattern in contact with a metal electrode on a second substrate, and
firing and curing the green circuit pattern in the contact state for thereby forming a conductive circuit and bonding the first and second substrates together.

5. The method for forming a conductive circuit according to claim 1, comprising the steps of:
printing the ink composition on a cured conductive circuit pattern on a first substrate which has been previously formed by printing, firing and curing a circuit pattern of predetermined configuration on the first substrate, to form a green circuit pattern of predetermined configuration,
placing the green circuit pattern in contact with a cured conductive circuit pattern on a second substrate which has been previously formed by printing, firing and curing a circuit pattern of conformable configuration on the second substrate, and
firing and curing the green circuit pattern in the contact state for thereby forming a conductive circuit and bonding the first and second substrates together.

## Patentansprüche

1. Verfahren zur Bildung einer leitfähigen Schaltung, umfassend die Schritte:
Drucken einer Tintenzusammensetzung auf ein erstes Substrat zur Bildung eines grünen Schaltungsmusters mit vorbestimmter Konfiguration,
Platzieren des grünen Schaltungsmusters in Kontakt mit einer Lötelektrode, die als Metallelektrode dient, auf einem zweiten Substrat,
Erhitzen und Härten des grünen Schaltungsmusters in dem Kontaktzustand um hierdurch ein gehärtetes, leitfähiges Schaltungsmuster zu bilden, um so eine Struktur zu erzielen, bei der das gehärtete Schaltungsmuster an die Lötelektrode gebunden ist,
Erwärmen, um die Lötelektrode zu schmelzen, um zu ermöglichen, dass das gehärtete leitfähige Schaltungsmuster von der Lötelektrode getrennt wird, und Wiedergewinnen des ersten Substrats mit dem gehärteten, leitfähigen Schaltungsmuster zum Nachbearbeiten,
Vorsehen des wiedergewonnen Substrats, ohne das zum Binden verwendete, gehärtete Schaltungsmuster zu entfernen,
Drucken der Tintenzusammensetzung auf das Substrat zur Bildung eines weiteren grünen Schaltungsmusters mit vorbestimmter Konfiguration, und Platzieren des weiteren grünen Schaltungsmusters in Kontakt mit einer Metallelektrode auf einem anderen Substrat, oder Drucken der Tintenzusammensetzung auf eine Metallelektrode auf einem anderen Substrat zur Bildung eines weiteren grünen Schaltungsmusters, und Platzieren des weiteren grünen Schaltungsmusters in Kontakt mit dem gehärteten Schaltungsmuster auf dem Substrat, das durch das Nachbearbeitungsverfahren wiedergewonnen wurde,
Erhitzen und Härten des weiteren grünen Schaltungsmusters im Kontaktzustand, um hierdurch eine leitfähige Schaltung zu bilden und Miteinanderverbinden der Substrate,
wobei die Tintenzusammensetzung eine im Wesentlichen lösungsmittelfreie, flüssige, additionshärtbare, leitfähige, schaltungsbildende Tintenzusammensetzung ist, umfassend
(A) ein Organopolysiloxan mit mindestens zwei Silizium-gebundenen Alkenylgruppen,
(B) ein Organohydrogenpolysiloxan mit mindestens zwei Silizium-gebundenen Wasserstoffatomen,
(C) leitfähige Teilchen,
(D) ein Thixotropiemittel, gewählt aus der Gruppe, bestehend aus Ruß, Zinkweiß, Zinnoxid, Zinn-Antimonoxid und Siliziumcarbid, und
(E) einen Hydrosilylierungskatalysator.

2. Verfahren zur Bildung einer leitfähigen Schaltung nach Anspruch 1, umfassend die Schritte:
Drucken der Tintenzusammensetzung auf eine Metallelektrode auf einem ersten Substrat zur Bildung eines grünen Schaltungsmusters mit vorbestimmter Konfiguration,
Platzieren des grünen Schaltungsmusters in Kontakt mit einem gehärteten, leitfähigen Schaltungsmuster auf einem zweiten Substrat, das vorausgehend gebildet worden ist durch Drucken, Erhitzen und Härten eines Schaltungsmusters mit angepasster Konfiguration auf dem zweiten Substrat, und
Erhitzen und Härten des grünen Schaltungsmusters im Kontaktzustand, um hierdurch eine leitfähige Schaltung zu bilden und Miteinanderverbinden des ersten und zweiten Substrats.

3. Verfahren zur Bildung einer leitfähigen Schaltung nach Anspruch 1, umfassend die Schritte:
Drucken der Tintenzusammensetzung auf eine Metallelektrode auf einem ersten Substrat zur Bildung eines grünen Schaltungsmusters mit vorbestimmter Konfiguration,
Platzieren des grünen Schaltungsmusters in Kontakt mit einer Metallelektrode auf einem zweiten Substrat, und
Erhitzen und Härten des grünen Schaltungsmusters im Kontaktzustand, um hierdurch eine leitfähige Schaltung zu bilden, und Miteinanderverbinden des ersten und zweiten Substrats.

4. Verfahren zur Bildung einer leitfähigen Schaltung nach Anspruch 1, umfassend die Schritte:
Drucken der Tintenzusammensetzung auf ein gehärtetes, schaltfähiges Schaltungsmuster auf einem ersten Substrat, das vorausgehend gebildet worden ist durch Drucken, Erhitzen und Härten eines Schaltungsmusters mit vorbestimmter Konfiguration auf dem ersten Substrat, zur Bildung eines grünen Schaltungsmusters mit vorbestimmter Konfiguration,
Platzieren des grünen Schaltungsmusters in Kontakt mit einer Metallelektrode auf einem zweiten Substrat, und
Erhitzen und Härten des grünen Schaltungsmusters im Kontaktzustand, um hierdurch eine leitfähige Schaltung zu bilden und Miteinanderverbinden des ersten und zweiten Substrats.

5. Verfahren zur Bildung einer leitfähigen Schaltung nach Anspruch 1, umfassend die Schritte:
Drucken der Tintenzusammensetzung auf ein gehärtetes, leitfähiges Schaltungsmuster auf einem ersten Substrat, das vorausgehend gebildet worden ist durch Drucken, Erhitzen und Härten eines Schaltungsmusters mit vorbestimmter Konfiguration auf dem ersten Substrat, um ein grünes Schaltungsmuster mit vorbestimmter Konfiguration zu bilden,
Platzieren des grünen Schaltungsmusters in Kontakt mit einem gehärteten, leitfähigen Schaltungsmuster auf einem zweiten Substrat, das vorausgehend gebildet worden ist durch Drucken, Erhitzen und Härten eines Schaltungsmusters mit angepasster Konfiguration auf dem zweiten Substrat, und
Erhitzen und Härten des grünen Schaltungsmusters im Kontaktzustand, um hierdurch eine leitfähige Schaltung zu bilden und Miteinanderverbinden des ersten und zweiten Substrats.

## Revendications

1. Un procédé pour former un circuit conducteur comprenant les étapes consistant à:
imprimer une composition d'encre sur un premier substrat pour former un motif de circuit vert de configuration prédéterminée,
placer le motif de circuit vert en contact avec une électrode de soudage servant en tant qu'électrode métallique sur un second substrat,
mettre à feu et durcir le motif de circuit vert à l'état de contact pour ainsi former un motif de circuit conducteur durci, fournissant ainsi une structure dans laquelle le motif de circuit durci est lié à l'électrode de soudage,
chauffer afin de fondre l'électrode de soudage, permettant au motif de circuit conducteur durci d'être séparé de l'électrode de soudage, et récupérer le premier substrat ayant le motif de circuit conducteur durci pour le remaniement,
assurer le substrat récupéré sans enlever le motif de circuit durci utilisé pour la jonction,
imprimer la composition d'encre sur le substrat afin de former un autre motif de circuit vert ayant une configuration prédéterminée, et placer l'autre motif de circuit vert en contact avec une électrode métallique sur un autre substrat, ou imprimer la composition d'encre sur une électrode métallique sur un autre substrat afin de former un autre motif de circuit vert, et placer l'autre motif de circuit vert en contact avec le motif de circuit durci sur le substrat récupéré par le procédé de remaniement,
mettre à feu et durcir l'autre motif de circuit vert à l'état de contact afin d'ainsi former un circuit conducteur et lier les substrats ensemble,
ladite composition d'encre étant une composition d'encre étant sensiblement exempte de solvants, liquide, durcissable par addition, formant circuit conducteur comprenant
(A) un organopolysiloxane ayant au moins deux groupes alcényle liés à du silicium,
(B) un organohydrogénopolysiloxane ayant au moins deux atomes d'hydrogène liés au silicium,
(C) des particules conducteur,
(D) un agent thixotrope choisi parmi constitué par le noir de carbone, le blanc de zinc, l'oxyde d'étain, l'oxyde d'étain et d'antimoine, et le carbure de silicium, et
(E) un catalyseur d'hydrosilylation.

2. Le procédé pour former un circuit conducteur selon la revendication 1, comprenant les étapes consistant à:
imprimer la composition d'encre sur une électrode métallique sur un premier substrat afin de former un motif de circuit vert de configuration prédéterminée,
placer le motif de circuit vert en contact avec un circuit conducteur durci sur un second substrat préalablement formé par impression, mettre à feu et durcir un motif de circuit de configuration conformable sur le second substrat, et
mettre à feu et durcir du motif de circuit verre à l'état de mise en contact pour ainsi former un circuit conducteur est lié les premiers et seconds substrats ensemble.

3. Le procédé pour former un circuit conducteur selon la revendication 1, comprenant les étapes consistant à:
imprimer la composition d'encre sur une électrode métallique sur un premier substrat pour former un motif de circuit vert de configuration prédéterminée,
placer le motif de circuit vert en contact avec une électrode métallique sur un second substrat, et
mettre à feu et durcir le motif de circuit vert à l'état de contact pour ainsi former un circuit conducteur et lier les premier et second substrats ensemble.

4. Le procédé pour former un circuit conducteur selon la revendication 1, comprenant les étapes consistant à:
imprimer la composition d'encre sur un motif de circuit conducteur durci sur un premier substrat qui a été préalablement formé en imprimant, et mettre à feu et durcir un motif de circuit de configuration prédéterminée sur le premier substrat, afin de former un motif de circuit vert de configuration prédéterminée,
placer le motif de circuit vert en contact avec un motif de circuit conducteur durci sur un second substrat, et
mettre à feu et durcir le motif de circuit vert à l'état de contact afin d'ainsi former un circuit conducteur et lier les premiers et seconds substrats ensemble.

5. Le procédé pour former un circuit conducteur selon la revendication 1, comprenant les étapes consistant à:
imprimer la composition d'encre sur un motif de circuit conducteur durci sur un premier substrat qui a été formé préalablement en imprimant, mettant à feu et durcissant un motif de circuit de configuration conformable sur le second substrat, et
mettre à feu et durcir le motif de circuit vert à l'état de contact afin d'ainsi former un circuit conducteur et lier les premiers et seconds substrats ensemble.
